# FASCICULE DE BREVET EUROPEEN

(11) **EP 0 362 014 B1**
(45) Date de publication et mention de la délivrance du brevet: **07.12.1994**
(21) Numéro de dépôt: 89402519.6
(22) Date de dépôt: 14.09.1989
(51) Int. Cl.: F02P 3/08, F02P 15/00, H03K 3/57, H03K 4/02, H02M 9/04, F02C 7/266

(54) **Générateur d'allumage haute énergie notamment pour turbine à gaz**
Zündungsgenerator mit einer hohen Energie, insbesondere für Gasturbinen
High energy ignition generator, especially for a gas turbine

(30) Priorité: 20.09.1988 FR 8812272
(43) Date de publication de la demande: 04.04.1990
(73) Titulaire: SAGEM SA, F-75783 Paris Cédex 16 (FR)
(72) Inventeur: Balland, Patrick, F-92500 Rueil Malmaison (FR)
(74) Mandataire: Fort, Jacques

(56) Documents cités:
- EP-A- 0 055 176
- EP-A- 0 091 206
- DE-A- 1 808 737
- FR-A- 1 338 075
- US-A- 3 629 652
- US-A- 3 869 645
- US-A- 3 870 028

## Description

La présente invention concerne un générateur d'allumage haute énergie notamment pour turbine à gaz.

On connait déjà dans l'état de la technique un certain nombre de générateurs de ce type, comportant une source d'énergie raccordée à un premier circuit comprenant un condensateur de stockage d'énergie, une inductance et une bougie d'allumage, en série, une diode de roue libre étant reliée en parallèle aux bornes de l'inductance et de la bougie et des moyens de court-circuitage du premier circuit de manière à engendrer des étincelles entre les électrodes de la bougie. De tels générateurs sont décrits par exemple dans US-A-3 629 652.

Dans l'état de la technique, les moyens de court-circuitage sont constitués par un éclateur formé par exemple par un tube à gaz et qui joue le rôle de commutateur de puissance et de référence de tension.

Cependant, ces dispositifs présentent un certain nombre d'inconvénients dans la mesure ou l'éclateur présente une durée de vie limitée et un rendement très faible.

Le but de l'invention est donc de résoudre ces problèmes en proposant un générateur d'allumage qui soit simple, fiable, présentant une durée de vie augmentée par rapport à celle des dispositifs de l'état de la technique, et pouvant fonctionner à des températures très élevées.

A cet effet, l'invention a pour objet un générateur d'allumage haute énergie notamment pour turbine à gaz, du type comportant une source d'énergie raccordée à un premier circuit comprenant un condensateur de stockage d'énergie, une inductance et une bougie d'allumage, en série, une diode de roue libre étant reliée en parallèle aux bornes de l'inductance et de la bougie et des moyens de court-circuitage du premier circuit de manière à engendrer des étincelles entre les électrodes de la bougie, caractérisé en ce que les moyens de court-circuitage comprennent au moins un organe commutateur à semi-conducteur commandé par des moyens de comparaison de la tension aux bornes du condensateur de stockage à une première tension de référence, et en ce que des moyens de commande de la charge du condensateur à un premier rythme pendant une première période de temps et à un second rythme pendant une seconde période de temps, le second rythme étant supérieur au premier, sont interposés entre la source d'énergie et le premier circuit.

Avantageusement, les moyens de commande comprennent un oscillateur commandé par tension, dont l'entrée est reliée à la source d'énergie et dont la sortie est reliée à une bascule commandant l'alimentation d'un enroulement primaire d'un transformateur dont un premier enroulement secondaire est raccordé audit premier circuit à travers des moyens de redressement, l'oscillateur commandé par tension délivrant des trains d'impulsions présentant une première et une seconde fréquences déterminant les premier et second rythmes de charge du condensateur sous la commande de moyens de déclenchement asservis à la fréquence des étincelles entre les électrodes de la bougie.

L'invention sera mieux comprise à l'aide de la description qui va suivre, donnée uniquement à titre d'exemple et faite en se référant aux dessins annexés, sur lesquels :
- la Fig.1 représente un schéma synoptique d'un générateur d'allumage haute énergie selon l'invention; et
- la Fig.2 représente un chronogramme illustrant le fonctionnement du générateur représenté sur la Fig.1.

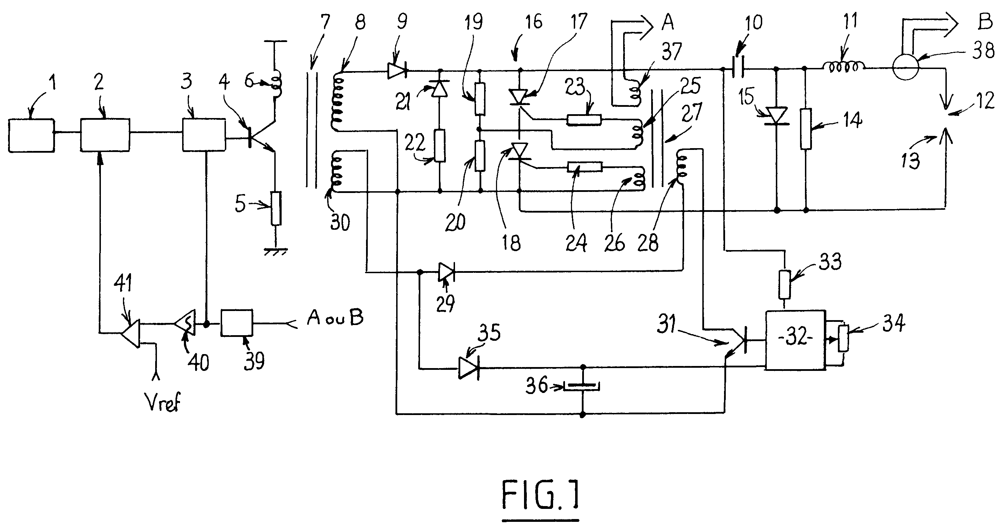

Ainsi qu'on peut le voir sur la Fig.1, qui représente un schéma synoptique d'un générateur d'allumage haute énergie notamment pour turbine à gaz, selon son invention, celui-ci comporte une source d'énergie 1 reliée à l'entrée d'un oscillateur commandé par tension 2 dont la sortie est reliée à une bascule 3. La sortie de cette bascule est reliée à la base d'un transistor NPN 4 dont l'émetteur est relié à la masse à travers une résistance 5 et dont le collecteur est relié à une borne d'un enroulement primaire 6 d'un transformateur 7, l'autre borne de cet enroulement primaire du transformateur étant reliée à l'alimentation.

L'une des bornes d'un premier enroulement secondaire 8 de ce transformateur 7 est reliée à l'anode d'une diode de redressement 9 dont la cathode est reliée à un premier circuit comprenant un condensateur de stockage d'énergie 10, une inductance 11 et une bougie d'allumage 12, en série, les électrodes de cette bougie étant désignées par 13.

Une résistance 14 et une diode de roue libre 15 sont également connectées en parallèle aux bornes de l'inductance 11 et de la bougie 12.

Des moyens de court-circuitage 16 sont également connectés en parallèle aux bornes de ce premier circuit pour engendrer de manière connue en soi des étincelles entre les électrodes de la bougie 12.

Ces moyens de court-circuitage comprennent au moins un organe commutateur à semi-conducteur, par exemple deux thyristors 17 et 18 connectés en série comme représenté sur cette figure. Des résistances d'équilibrage 19 et 20 sont avantageusement connectées en parallèle aux bornes des thyristors 17 et 18 respectivement, de manière à équilibrer ce montage. Une diode 21 dont la cathode est réliée à la cathode de la diode 9, et une résistance 22 en serie avec cette diode 21, sont également connectées aux bornes de ces thyristors de manière à constituer un circuit de protection de ceux-ci. Les gâchettes de ces thyristors 17 et 18 sont respectivement reliées à des résistances 23 et 24 connectées à des enroulements secondaires respectivement 25 et 26 d'un transformateur d'impulsions 27. Ce transformateur d'impulsions 27 possède un enroulement primaire 28 dont l'une des bornes est reliée à la cathode d'une diode 29 dont l'anode est reliée à une borne d'un second enroulement secondaire 30 du transformateur 7 mentionné précédemment.

L'autre borne de l'enroulement primaire 28 du transformateur d'impulsions 27 est reliée au collecteur d'un transistor NPN 31 dont l'émetteur est relié à l'autre borne du second enroulement secondaire 30 du transformateur 7. La base de ce transistor NPN 31 est reliée à des moyens de comparaison 32 de la tension aux bornes du condensateur 10 à une première tension de référence.

A cet effet, l'une des bornes d'entrée de ces moyens de comparaison 32 est reliée à la borne d'entrée du condensateur 10 à travers une résistance 33 et ces moyens de comparaison sont également reliés à un potentiomètre 34 de fixation de la première tension de référence.

Ces moyens de comparaison 32 reçoivent leur alimentation du second enroulement secondaire 30 du transformateur 7 à travers une diode 35, un condensateur 36 connecté à la cathode de cette diode 35 et à l'autre borne de ce second enroulement secondaire 30 assurant un lissage de l'alimentation.

Le fonctionnement de cette partie du dispositif est le suivant.

L'oscillateur commandé par tension 2 engendre des trains d'impulsions attaquant la bascule 3 qui elle-même commande l'alimentation de l'enroulement primaire 6 du transformateur 7 à travers le transistor 4. Le premier enroulement secondaire 8 de celui-ci assure donc à travers la diode de redressement 9, la charge du condensateur de stockage 10 jusqu'à ce que l'image de la tension aux bornes de celui-ci soit au moins égale à la tension de référence déterminée par le potentiomètre 34, cette comparaison étant assurée par les moyens de comparaison 32.

Bien entendu, cette tension de référence peut également être délivrée par tous moyens asservis à la température de la turbine, pour asservir l'énergie des étincelles délivrées par le générateur à la température de cette turbine. Cette température est par exemple prélevée par tous capteurs de température appropriés.

Lorsque la tension aux bornes du condensateur 10 est suffisante, les moyens de comparaison 32 assurent la commande du transformateur d'impulsions 27 à travers le transistor 31, pour déclencher les thyristors 17 et 18 et ainsi court-circuiter le premier circuit mentionné précédemment afin d'engendrer des étincelles entre les électrodes de la bougie 12.

Il a été constaté lors d'essais effectués à très haute température, de l'ordre de 120 à 130°C, sur des turbines, que les thyristors devenaient passants et qu'un courant de fuite ainsi créé entraînait une augmentation de température supplémentaire dégradant encore le fonctionnement de ceux-ci.

Pour résoudre ces problèmes, les moyens de commande de l'alimentation du premier circuit, à savoir les composants assurant l'alimentation du transformateur 7 sont adaptés pour commander la charge du condensateur à un premier rythme pendant une première période de temps et à un second rythme pendant une seconde période de temps, le second rythme étant supérieur au premier.

Par ailleurs, ces moyens sont également asservis à la fréquence des étincelles entre les électrodes de la bougie 12 en prélevant un signal de fréquence d'étincelles, soit aux bornes d'un troisième enroulement secondaire 37 du transformateur d'impulsions 27 en A, soit directement sur la ligne d'alimentation de la bougie 12 par l'intermédiaire d'un transformateur d'intensité 38, en B.

L'un ou l'autre de ces signaux émanant des éléments 37 ou 38 décrits précédemment, est ensuite envoyé dans une bascule 39 dont la sortie est reliée à un intégrateur 40. La sortie de cet intégrateur est reliée à une borne d'un comparateur 41 dont l'autre borne reçoit une seconde tension de référence. La sortie de ce comparateur 41 est reliée à une borne de commande de l'oscillateur commandé par tension, ces composants constituant des moyens de déclenchement de l'oscillateur 2.

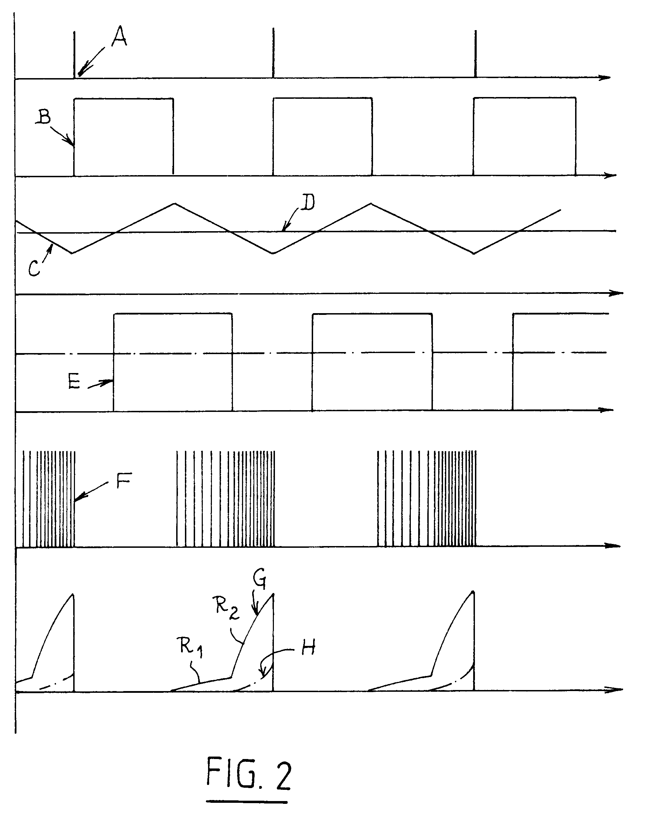

Le fonctionnement de cette partie du dispositif est illustré par le chronogramme représenté sur la Fig.2.

En A, sont représentées les étincelles produites à la bougie 12, ces étincelles fournissant une référence de fréquence.

En B, est représentée la sortie de la bascule 39 recevant sur son entrée le signal représenté en A. Ce signal de sortie de la bascule comprend des créneaux dont les fronts montants correspondent aux éclatements d'étincelles entre les électrodes de la bougie 12. Ce signal est ensuite intégré dans les moyens d'intégration 40 de manière à former un signal en dents de scie représenté en C. Par ailleurs, ce signal de sortie de la bascule 39 est également appliqué à la bascule 3 pour bloquer le fonctionnement de celle-ci et des composants connectés à la sortie de celle-ci.

Ce signal en dents de scie est comparé dans le comparateur 41 avec la seconde tension de référence représentée en D sur cette Fig.2 et appliquée à l'autre entrée de ce comparateur, de manière à former à la sortie du comparateur 41, un signal représenté en E illustrant un signal présentant des créneaux d'une durée correspondant au temps durant lequel le signal en dents de scie est supérieur à la seconde tension de référence.

Il va de soi que cette seconde tension de référence peut également être asservie à la température de la turbine, pour asservir la fréquence des étincelles délivrées par le générateur à la température de la turbine.

Le signal E de sortie du comparateur 41 est ensuite appliqué à l'oscillateur commandé par tension 2 de manière à commander celui-ci pour que durant une première période de temps, en présence d'un créneau dans le signal E et quand le créneau dans le signal B disparaît, il émette des impulsions à une première fréquence faible voire nulle de manière à assurer une charge à un premier rythme relativement faible voire nul du condensateur de stockage d'énergie 10, tandis qu'après la disparition du créneau dans le signal E, l'oscillateur envoie des impulsions à une seconde fréquence élevée de manière a accélérer la charge du condensateur de stockage d'énergie à un second rythme, ces impulsions sont représentées en F sur la Fig.2. Ceci permet de retarder la charge du condensateur de stockage d'énergie 10 et donc de réduire le temps pendant lequel le courant de fuite des thyristors est présent dans ceux-ci, entraînant une moindre augmentation de la température de ceux-ci.

Ainsi, et comme cela est représenté en G sur cette Fig.2, la charge du condensateur est assurée à un premier rythme R1 pendant une première période de temps et à un second rythme R2 pendant une seconde période de temps, ce second rythme étant nettement supérieur au premier.

Le courant de fuite des thyristors illustré par H sur cette figure, n'apparaît donc plus que durant la période de temps pendant laquelle le rythme de charge du condensateur est R2, ce qui limite l'échauffement de ceux-ci.

Par ailleurs, l'asservissement à la température de la turbine, de l'énergie et de la fréquence des étincelles délivrées par le générateur, permet également de limiter l'échauffement des thyristors de celui-ci.

Il va de soi que bien que l'on ait représenté en C, un signal en dents de scie équilibré, des signaux déséquilibrés peuvent également être utilisés pour faire varier les première et seconde périodes de temps de charge du condensateur.

## Revendications

1. Générateur d'allumage haute énergie notamment pour turbine à gaz, du type comportant une source d'énergie (1) raccordée à un premier circuit comprenant un condensateur (10) de stockage d'énergie, une inductance (11) et une bougie d'allumage (12), en série, une diode (15) de roue libre étant reliée en parallèle aux bornes de l'inductance (11) et de la bougie d'allumage (12) et des moyens de court-circuitage (16) du premier circuit de manière à engendrer des étincelles entre les électrodes de la bougie (12), caractérisé en ce que les moyens de court-circuitage (16) comprennent au moins un organe commutateur à semi-conducteur (17,18) commandé par des moyens de comparaison (32) de la tension aux bornes du condensateur de stockage (10) à une première tension de référence, et en ce que des moyens de commande (2,3,4,7;39,40,41) de la charge du condensateur (10) à un premier rythme (R1) pendant une première période de temps et à un second rythme (R2) pendant une seconde période de temps, le second rythme étant supérieur au premier, sont interposés entre la source d'énergie (1) et le premier circuit.

2. Générateur selon la revendication 1, caractérisé en ce que les moyens de commande comprennent un oscillateur commandé par tension (2) dont l'entrée est reliée à la source d'énergie (1) et dont la sortie est reliée à une première bascule (3) commandant l'alimentation d'un enroulement primaire (6) d'un transformateur (7) dont un premier enroulement secondaire (8) est relié au premier circuit à travers des moyens de redressement (9), l'oscillateur commandé par tension (2) délivrant des trains d'impulsions présentant une première et une seconde fréquences déterminant les premier et second rythmes (R1,R2) de charge du condensateur (10) sous la commande de moyens de déclenchement (37;38;39, 40,41) asservis à la fréquence des étincelles entre les électrodes de la bougie (12).

3. Générateur selon la revendication 2, caractérisé en ce que les moyens de déclenchement comprennent des moyens de détermination de la fréquence des étincelles (37;38) reliés à une seconde bascule (39) dont la sortie est reliée à des moyens d'intégration (40) et à la première bascule (3), la sortie de ces moyens d'intégration (40) étant reliée à une borne d'entrée d'un comparateur (41) dont l'autre borne d'entrée reçoit une seconde tension de référence, et dont la sortie est reliée à une entrée de commande de l'oscillateur commandé par tension (2), de manière à commander l'émission par celui-ci des impulsions à la première et la seconde fréquences en fonction du résultat de la comparaison.

4. Générateur selon la revendication 3, caractérisé en ce que les moyens de détermination de la fréquence des étincelles comprennent un transformateur d'intensité (38) connecté dans la ligne d'alimentation de la bougie (12).

5. Générateur selon la revendication 3, caractérisé en ce que les moyens de détermination de la fréquence des étincelles comprennent un enroulement secondaire (37) d'un transformateur d'impulsions (27) dont au moins un autre enroulement secondaire (25,26) est relié à la borne de commande de l'organe commutateur a semi-conducteur (17,18), l'enroulement primaire (28) de ce transformateur d'impulsions (27) étant relié aux moyens de comparaison (32) de la tension aux bornes du condensateur de stockage (10) à la première tension de référence.

6. Générateur selon l'une quelconque des revendications précédentes, caractérisé en ce que l'organe commutateur à semi-conducteur est un thyristor (17,18).

7. Générateur selon la revendication 6, caractérisé en ce qu'il comporte deux thyristors (17,18) connectés en série.

8. Générateur selon l'une quelconque des revendications précédentes, caractérisé en ce que le premier rythme est nul.

9. Générateur selon la revendication 1, caractérisé en ce que la première tension de référence est asservie à la température de la turbine.

10. Générateur selon la revendication 3, caractérisé en ce que la seconde tension de référence est asservie à la température de la turbine.

## Claims

1. High-energy ignition generator especially for a gas turbine, of the type including an energy source (1) connected up to a first circuit comprising an energy-storage capacitor (10), an inductor (11) and an ignition plug (12) in series, a freewheeling diode (15) connected in parallel to the terminals of the inductor (11) and of the ignition plug (12), and means (16) for short-circuiting the first circuit so as to generate sparks between the electrodes of the plug (12); characterized in that the short-circuiting means (16) comprise at least one semiconductor switching member (17,18) controlled by means (32) for comparing the voltage at the terminals of the storage capacitor (10) to a first reference voltage; and in that means (2,3,4,7;39,40,41) for controlling the charging of the capacitor (10) at a first rate (R₁) for a first period of time and at a second rate (R₂) for a second period of time, the second rate being greater than the first rate, are interposed between the energy source (1) and the first circuit.

2. Generator according to Claim 1, characterized in that the control means comprise a voltage-controlled oscillator (2), the input of which is connected to the energy source (1) and the output of which is connected to a first flip-flop (3) controlling the supply for a primary winding (6) of a transformer (7), a first secondary winding (8) of which is connected to the first circuit via rectifying means (9), the voltage-controlled oscillator (2) delivering pulse trains having a first frequency and a second frequency determining the first and second rates (R₁,R₂) of charging of the capacitor (10) under the control of triggering means (37;38;39, 40,41) slaved to the frequency of the sparks between the electrodes of the plug (12).

3. Generator according to Claim 2, characterized in that the triggering means comprise means (37;38) for determining the frequency of the sparks, these means being connected to a second flip-flop (39) the output of which is connected to integration means (40) and to the first flip-flop (3), the output of these integration means (40) being connected to an input terminal of a comparator (41) the other input terminal of which receives a second reference voltage, and the output of which is connected to an input for controlling the voltage-controlled oscillator (2) so as to control the emission by the latter of the pulses with the first frequency and the second frequency depending on the result of the comparison.

4. Generator according to Claim 3, characterized in that the means for determining the frequency of the sparks comprise a current transformer (38) connected into the supply line for the plug (12).

5. Generator according to Claim 3, characterized in that the means for determining the frequency of the sparks comprise a secondary winding (37) of a pulse transformer (27), at least one other secondary winding (25,26) of which is connected to the control terminal of the semiconductor switching member (17,18), the primary winding (28) of this pulse transformer (27) being connected to the means (32) for comparing the voltage at the terminals of the storage capacitor (10) to the first reference voltage.

6. Generator according to any one of the preceding claims, characterized in that the semiconductor switching member is a thyristor (17,18).

7. Generator according to Claim 6, characterized in that it includes two thyristors (17,18) connected in series.

8. Generator according to any one of the preceding claims, characterized in that the first rate is zero.

9. Generator according to Claim 1, characterized in that the first reference voltage is slaved to the temperature of the turbine.

10. Generator according to Claim 3, characterized in that the second reference voltage is slaved to the temperature of the turbine.

## Patentansprüche

1. Zündungsgenerator mit einer hohen Energie, insbesondere für Gasturbinen, der eine Energiequelle (1) besitzt, die an einen ersten Stromkreis angeschlossen ist, der aus einem Energiespeicherkondensator (10), einer Induktanz (11) und einer Zündkerze (12) in Serie besteht, wobei eine Freilaufdiode (15) parallel an die Klemmen der Induktanz (11) und der Zündkerze (12) und der Kurzschlußelemente (16) des ersten Stromkreises geschaltet ist, um Zwischen den Elektroden der Zündkerze (12) Funken zu erzeugen, **dadurch gekennzeichnet**, **daß** die Kurzschlußmittel (16) mindestens ein Halbleiter-Schaltelement (17, 18) beinhalten, das durch Mittel (32) zum Vergleich der Spannung an den Klemmen des Speicherkondensators (10) mit einer ersten Bezugsspannung gesteuert wird, und daß die Steuerelemente (2, 3, 4, 7; 39, 40, 41) für das Laden des Kondensators (10) mit einem ersten Takt (R1) in einer ersten Periode und mit einem zweiten Takt (R2) in einer zweiten Periode zwischen die Energiequelle (1) und den ersten Stromkreis geschaltet sind, wobei der zweite Takt höher als der erste ist.

2. Generator gemäß Anspruch 1, **dadurch gekennzeichnet, daß** die Steuerelemente einen spannungsgesteuerten Oszillator (2) beinhalten, dessen Eingang mit der Energiequelle (1) verbunden ist und dessen Ausgang an eine erste Kippschaltung (3) angeschlossen ist, die die Einspeisung einer Primärwicklung (6) eines Transformators (7) steuert, dessen erste Sekundärwicklung (8) über Gleichrichterlemente (9) am ersten Stromkreis angeschlossen ist, wobei der spannungsgesteuerte Oszillator (2) Impulsfolgen abgibt, die eine erste und eine zweite Frequenz aufweisen und den ersten und zweiten Takt (R1, R2) für das Laden des Kondensators (10) unter Steuerung von Triggerelementen (37, 38, 39, 40, 41) bestimmen, die von der Frequenz der Funken zwischen den Elektroden der Zündkerze (12) geregelt werden.

3. Generator gemäß Anspruch 2, **dadurch gekennzeichnet, daß** die Triggerelemente Mittel zur Festlegung der Funkenfrequenz (37, 38) beinhalten, die mit einer zweiten Kippschaltung (39) verbunden sind, deren Ausgang an Integrationselemente (40) und an der ersten Kippschaltung (3) angeschlossen ist, wobei der Ausgang dieser Integrationselemente (40) an einer Eingangsklemme eines Vergleichers (41) angeschlossen ist, dessen andere Eingangsklemme mit einer zweiten Bezugsspannung beaufschlagt wird, und dessen Ausgang mit einem Steuereingang des spannungsgesteuerten Oszillators (2) verbunden ist, um die Ausgabe von Impulsen dieses Oszillators mit einer ersten und zweiten Frequenz, je nach dem Ergebnis des Vergleichs, zu steuern.

4. Generator gemäß Anspruch 3, **dadurch gekennzeichnet, daß** die Mittel zur Festlegung der Funkenfrequenz einen Stromwandler (38) beinhalten, der an der Einspeisung der Zündkerze (12) angeschlossen ist.

5. Generator gemäß Anspruch 3, **dadurch gekennzeichnet, daß** die Mittel zur Festlegung der Funkenfrequenz eine Sekundärwicklung (37) eines Impulstransformators (27) beinhalten, von dem mindestens eine weitere Sekundärwicklung (25, 26) an der Steuerklemme des Halbleiter-Schaltelements (17, 18) angeschlossen ist, wobei die Primärwicklung (28) dieses Impulstransformators (27) mit den Mitteln zum Vergleich (32) der Spannung an den Klemmen des Speicherkondensators (10) mit der ersten Bezugsspannung angeschlossen ist.

6. Generator gemäß jedem beliebigen vorgenannten Anspruch, **dadurch gekennzeichnet, daß** das Halbleiter-Schaltelement ein Thyristor (17, 18) ist.

7. Generator gemäß Anspruch 6, **dadurch gekennzeichnet, daß** er zwei in Serie geschaltete Thyristoren (17, 18) beinhaltet.

8. Generator gemäß jedem beliebigen vorgenannten Anspruch, **dadurch gekennzeichnet, daß** der erste Takt Null ist.

9. Generator gemäß Anspruch 1, **dadurch gekennzeichnet, daß** die erste Bezugsspannung von der Turbinentemperatur geregelt wird.

10. Generator gemäß Anspruch 3, **dadurch gekennzeichnet, daß** die zweite Bezugsspannung von der Turbinentemperatur geregelt wird.
